# EUROPEAN PATENT APPLICATION

(11) **EP 2 050 780 A2**
(43) Date of publication of application: **22.04.2009**
(21) Application number: 08166657.0
(22) Date of filing: 15.10.2008
(51) Int. Cl.: C08J 7/04, C08J 7/18, H01L 51/50

(54) **Barrier laminate, barrier film substrate, device, and method for producing barrier laminate**

(30) Priority: 16.10.2007 JP 2007269151; 26.12.2007 JP 2007333961; 04.02.2008 JP 2008024054
(71) Applicant: Fujifilm Corporation, Tokyo 106-0031 (JP)
(72) Inventor: Tateishi, Tomomi, Kanagawa 250-0193 (JP)
(74) Representative: HOFFMANN EITLE

(57) **Abstract**

Disclosed is a barrier laminate having much better barrier property. The barrier laminate has at least one organic layer and at least one inorganic layer, wherein the organic layer is formed by curing a composition containing a polymerizing compound and a photopolymerization initiator having at least two sites capable of initiating polymerization in one molecule, through irradiation with light.

## Description

### FIELD OF THE INVENTION

The present invention relates to a barrier laminate, and to a barrier film substrate comprising the barrier laminate, devices such as an organic EL device and an electronic paper, and optical parts, and further to a method for producing the barrier laminate.

### BACKGROUND ART

Heretofore it is known that, in producing an organic/inorganic laminate barrier film substrate having a laminate structure of an organic layer and an inorganic layer, the presence of no defects in the organic layer is extremely important in order that an inorganic layer and the like may be laminated on the organic layer to exhibit better barrier properties. Mostly the inorganic layer is formed through vacuum vapor deposition, but this case is problematic in that the volatile component in the organic layer may evaporate away in the vacuum atmosphere and, in addition, when the volatile component evaporates away, the volatile component may leave defects in the film surface and therefore the inorganic layer could not be formed uniformly on organic layer.

JP-A 2002-256092 discloses a hard coat film characterized by having a cured hard coat layer formed by applying a curable composition that contains a photocurable substance and an oligomer-type photopolymerization initiator, onto the surface of a substrate followed by irradiation with light for curing. JP-A 2003-292652 describes use of a heat-treated substrate film in the constitution as in JP-A 2002-256092.

Further, JP-A 2000-167999 discloses a film having a cured coating layer of a radiation-curable resin composition characterized by containing a radiation-curable polyfunctional (meth)acrylate having at least two (meth)acryloyl groups in the molecule, a compound having a copolymerizable unsaturated double bond at the terminal and/or a compound not having a copolymerizable unsaturated double bond, and a photopolymerization initiator having a molecular weight of at least 250.

However, the application of these techniques to an organic/inorganic hybrid barrier laminate has heretofore been made at all.

JP-A 2002-187906 describes a high-molecular-weight photopolymerization initiator that comprises a copolymer having a vinylic compound unit having a functional group capable of generating a radical through irradiation with active rays and an addition-polymerizing functional group in the molecule, and a monomer unit copolymerizable with the vinylic compound.

### SUMMARY OF THE INVENTION

The present invention is to solve the above-mentioned problems in producing a barrier laminate having an organic layer and an inorganic layer, and to provide a barrier laminate having an improved barrier property, especially a barrier film substrate having the barrier laminate formed on a substrate film.

Given the situation as above, the present inventors have assiduously studied and, as a result, have found that the above-mentioned problems can be solved by the present invention that provides the following:
(1) A barrier laminate having at least one organic layer and at least one inorganic layer, wherein the organic layer is formed by curing a composition containing a polymerizing compound and a photopolymerization initiator having at least two sites capable of initiating polymerization in one molecule, through irradiation with light.
(2) The barrier laminate of (1), wherein the photopolymerization initiator is a compound containing a structural unit of the following formula (A): 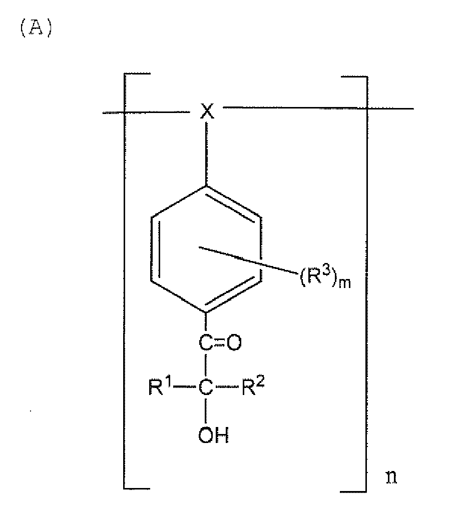 (wherein X represents a linear alkylene group or a branched alkylene group; R¹ and R² each represent a linear alkyl group or a branched alkyl group; R³ represents a substituent; m indicates an integer of from 0 to 4; n indicates an integer of from 2 to 50).
(3) The barrier laminate of (2), wherein n is an integer of from 2 to 20.
(4) The barrier laminate of any one of (1) to (3), wherein the molecular weight of the non-radical component of the photopolymerization initiator is less than 70 or at least 600.
(5) The barrier laminate of any one of (1) to (4), wherein the polymerizing compound is an acrylate compound.
(6) The barrier laminate of any one of (1) to (5), wherein the inorganic layer contains at least one selected from metal oxides, metal nitrides, metal oxinitrides and metal carbides.
(7) The barrier laminate of any one of (1) to (6), wherein at least two organic layers and at least two inorganic layers are alternately laminated.
(8) A barrier film substrate comprising a substrate film and a barrier laminate of any one of (1) to (7) provided on the substrate film.
(9) A barrier film substrate comprising a substrate film and a barrier laminate having at least one organic layer and at least one inorganic layer on the substrate film, wherein the number of the defects having a length of at least 1 µm in the surface of the barrier laminate is at most 30/cm².
(10) The barrier film substrate of (9), wherein the barrier laminate is a barrier laminate of any one of (1) to (7).
(11) A device comprising a barrier film substrate of any one of (8) to (10) as the substrate thereof.
(12) A device sealed up with a barrier film substrate of any one of (8) to (10).
(13) A device sealed up with a barrier laminate of any one of (1) to (7).
(14) The device of any one of (11) to (13), which is an electronic device.
(15) The device of any one of (11) to (13), which is an organic EL device.
(16) A method for producing a barrier laminate comprising providing at least one organic layer and at least one inorganic layer on a support, wherein the organic layer is provided by curing a composition containing a polymerizing compound and a photopolymerization initiator having plural sites capable of initiating polymerization in one molecule, through irradiation with light.
(17) The method for producing a barrier laminate of (16), wherein the barrier laminate is a barrier laminate of any one of (1) to (7).
(18) The method for producing a barrier laminate of (16) or (17), wherein the inorganic layer is provided by vacuum vapor deposition.
(19) An optical part comprising a barrier film substrate of (10) as the substrate thereof.

The present invention has made it possible to provide a barrier laminate having significantly enhanced barrier capability. As a result, the invention has made it possible to significantly prolong the life of devices such as organic EL devices.

### DESCRIPTION OF THE PREFERRED EMBODIMENTS

The contents of the invention are described in detail hereinunder. In this description, the numerical range expressed by the wording "a number to another number" means the range that falls between the former number indicating the lowermost limit of the range and the latter number indicating the uppermost limit thereof. The organic EL device as referred to in the invention means an organic electroluminescent device. In this description, (meth)acylate means both acrylate and methacrylate.

### <Barrier Laminate>

The barrier laminate of the invention is a laminate having a barrier layer that has the function of preventing oxygen and moisture in air from penetrating therethrough; and concretely, it is a barrier laminate having at least one organic layer and at least one inorganic layer on at least one surface of a substrate, in which the organic layer is formed by curing a composition containing a polymerizing compound and a photopolymerization initiator having at least two sites capable of initiating polymerization in one molecule, through irradiation with light.

The barrier layer in the invention has at least one organic layer and at least one inorganic layer, and preferably has an alternately laminated structure of at least two organic layers and at least two inorganic layers.

Not specifically defined, the number of the layers that constitute the barrier laminate is typically preferably from 2 to 30, more preferably from 3 to 20. The barrier layer may be provided only on one surface of the substrate or on both surfaces thereof.

### (Organic Layer)

The organic layer in the invention is formed by curing a composition containing a polymerizing compound and a photopolymerization initiator having at least two sites capable of initiating polymerization in one molecule. Hereinafter, the photopolymerization initiator having at least two sites capable of initiating polymerization in one molecule is referred as the photopolymerization initiator in the invention.

### (1) Photopolymerization Initiator:

The photopolymerization initiator in the invention is characterized by having at least two sites capable of initiating polymerization in one molecule. Heretofore in forming an organic layer by the use of a photopolymerization initiator, employed is a photopolymerization initiator having only one site capable of initiating polymerization, and therefore, a plurality of radical compounds having different structures are generated through photocleavage, therefore causing fluctuations in reaction, and the formation of a uniform organic layer is difficult. As opposed to this, in the invention, a photopolymerization initiator having at least two sites capable of initiating polymerization in one molecule is used, and therefore, a uniform organic layer can be formed. In addition, another advantage of the photopolymerization initiator in the invention is that, even when the layer thickness is increased or the number of the layers is increased, the haze of the film may be kept small and the film strength may be kept high, or that is, the photopolymerization initiator contributes toward improving the properties of the film. Furthermore, the volatile component from the organic layer may be reduced and the inorganic layer to be laminated on the organic layer may be made uniform, as will be described hereinunder. The production yield of the barrier film substrate and the product comprising the barrier film can be thereby increased. Moreover, the handlability of the film is good in that its smell after curing may be reduced.

The effect and the mechanism of the photopolymerization initiator in the invention for improving the barrier property of the film are described below. In an ordinary photopolymerization initiator, a specific bond is cleaved through irradiation with UV rays or visible rays, and the radical thus generated by the cleavage initiates polymerization. In this, all the generated radicals do not always contribute toward polymerization initiation, but a part of them may take a hydrogen atom existing in the system to change into a non-radical component. In case where the molecular weight of the non-radical component is extremely small (for example, the molecular weight is less than 70), the component may not remain in the film under normal pressure, and it may cause no problem. On the other hand, in case where the molecular weight of the non-radical component is from 100 to 300, the component may vaporize under reduced pressure, therefore forming defects in the organic layer or the inorganic layer and lowering the production yield of the barrier film substrate. When the photopolymerization initiator in the invention is used, the formation of the volatile component having a molecular weight of from 100 to 300 may be reduced, and the defects may be prevented. In case where all molecular weight of the non-radical component is entirely less than 70 or at least 600, the defects may be remarkably prevented and the embodiment gives an especially favorable result.

The defects can be detected as follows: Using a 1000-power scanning electromicroscope, the surface of an inorganic layer is observed, and projections or recesses having a size of at least 1 µm, if any, may be detected as defects. Regarding their morphology, the defects may be linear or circular ones, or may have an indeterminate form. The defects having a length of at least 1 µm as referred to herein mean that, when the defects are linear, their length is at least 1 µm, when the defects are circular, their diameter is at least 1 µm, and when the defects have an indeterminate form, the length of the longest line existing therein is at least 1 µm.

In the barrier laminate of the invention, the number of the defects having a length of at least 1 µm existing in the surface thereof may be at most 30/cm², preferably at most 20/cm².

Preferred examples of the photopolymerization initiator for use in the invention are hydroxyacetophenone compounds, benzoin ether compounds and benzyl acetal compounds; and more preferred are hydroxyacetophenone compounds having a structural unit of the following formula (A).

Hydroxyketone oligomer-type initiators as the hydroxyacetophenone-type polymerization initiator for use in the invention are known as Esacure KIP series (trade name), and the photopolymerization initiator in the invention can be produced according to the production methods for them. 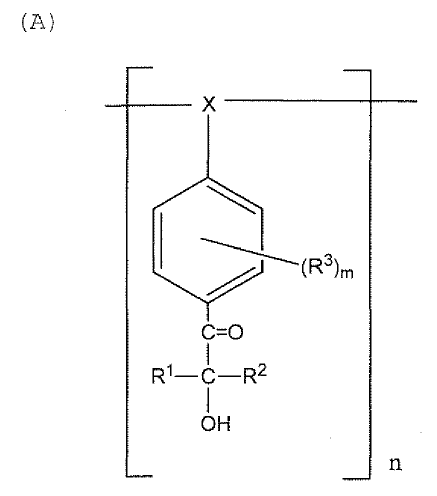 (wherein X represents a linear alkylene group or a branched alkylene group; R¹ and R² each represent a linear alkyl group or a branched alkyl group; R³ represents a substituent; m indicates an integer of from 0 to 4; n indicates an integer of from 2 to 50).

Not specifically defined, the number of the carbon atoms constituting the linear alkylene group or the branched alkylene group for X is preferably from 1 to 10, more preferably from 1 to 6, even more preferably from 1 to 3. Specific examples of X include >CH-CH₂-, >C(CH₃)-CH₂-, >C(C₂H₅)-CH₂-, >C(n-C₃H₇)-CH₂-, >C(i-C₃H₇)-CH₂-, >C(i-C₄H₉)-CH₂-, >C (i-C₈H₁₇) -CH₂- and >C(tert-C₈H₁₇) -CH₂-. In these, ">" means that the formula has two bonds.

Not specifically defined, the number of the carbon atoms constituting the linear alkyl group or the branched alkyl group for R¹ and R² is preferably from 1 to 3, more preferably from 1 to 2, even more preferably 1. The reason is because, as so mentioned in the above, when the polymerization initiator radical is, not participating in polymerization reaction, inactivated to be a non-radical component, then its molecular weight is small and it may hardly remain in the film. Specific examples of R¹ and R² include -CH₃, -C₂H₅, -CH(CH₃)₂, -(n-C₃H₇), -(i-C₃H₇), -(i-C₄H₉), -(i-C₈H₁₇) and -(tert-C₈H₁₇).

The substituent for R³ includes -CH₃, -C₂H₅, -CH(CH₃)₂, -(n-C₃H₇) and -(i-C₃H₇).

m is preferably 0. n is preferably from 5 to 20, more preferably from 5 to 10. When n is at most 20, its advantages are that the viscosity of the coating liquid for forming the organic layer may not be too high, and the handlability of the coating liquid may be easy.

In general, a hydrogen atom or a substituent bonds to the terminal of the compound containing the structural unit of formula (A). In this, the substituent may be a hydrocarbon group, including, for example, an alkyl group, a cycloalkyl group and an aryl group. The alkyl group may be a lower alkyl group, including, for example, a methyl group, an ethyl group, a propyl group and a butyl group. The cycloalkyl group includes, for example, a cyclohexyl group, a cycloheptyl group, a cyclooctyl group, and their alkyl-substituted derivatives. The aryl group includes, for example, a phenyl group and its alkyl-substituted derivatives.

The molecular weight of the photopolymerization initiator for use in the invention is preferably from 700 to 3000, more preferably from 700 to 1500.

Specific examples of the photopolymerization initiator for use in the invention include poly[2-hydroxy-2-methyl-1-[4-(1-methylvinyl)phenyl]propanone], poly[2-hydroxy-2-methyl-1-[4-vinylphenyl]propanone, poly[2-hydroxy-2-ethyl-1-[4-(1-methylvinyl)phenyl]propanone, poly[2-hydroxy-2-ethyl-1-[4-vinylphynyl]propanone], poly[2-hydroxy-2-methyl-1-[4-(1-ethylvinyl)phenyl]butanone, poly[2-hydroxy-2-methyl-1-[4-vinylphenyl]butanone], poly[2-hydroxy-2-ethyl-1-[4-(1-methylvinyl)phenyl]butanone] and poly[2-hydroxy-2-ethyl-1-[4-vinylphenyl]butanone]. One or more those photopolymerization initiators may be used either singly or as combined.

### (2) Polymerizing Compound:

The polymerizing compound for use in the invention may be widely any one capable of curing through irradiation with light, and may be any of unsaturated monomers, oligomers, resins and others. For example, acrylate compounds and styrene compounds are preferred.

The acrylate compounds include bifunctional or more polyfunctional radiation-curable acrylic compounds such as acrylates, urethane acrylates, polyester acrylates and epoxyacrylates; and preferred are ethylene glycol di(meth)acrylate, propylene glycol di(meth)acrylate, butylene glycol di(meth)acrylate, neopentyl glycol di(meth)acrylate, hexanediol di(meth)acrylate, trimethylolethane tri(meth)acrylate, trimethylolpropane tri(meth)acrylate, pentaerythritol tri(meth)acrylate, pentaerythritol tetra(meth)acrylate, pentaerythritol penta(meth)acrylate, dipentaerythritol hexa(meth)acrylate, glyceryl tri(meth)acrylate, triallyl (meth)acrylate, bisphenol A ethyleneoxide-modified di(meth)acrylate, etc.

The styrene compounds include bifunctional or more polyfunctional radiation-curable styrene compounds; and preferred are styrene, α-methylstyrene, 4-methylstyrene, etc.

One or more those polymerizing compounds may be used either singly or as combined.

Specific examples of the acrylate compounds are shown below, to which, however, the invention should not be limited.

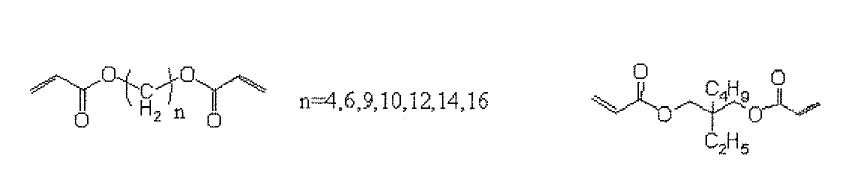

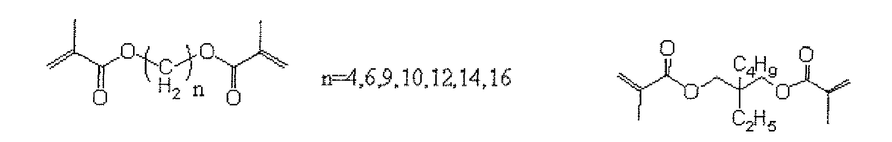

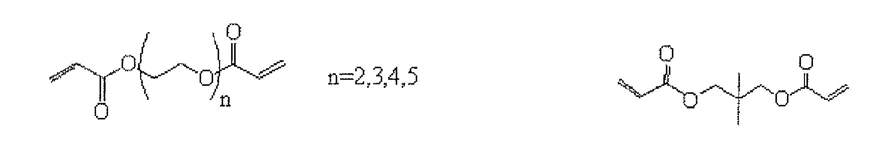

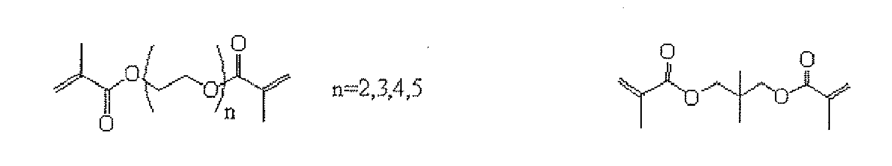

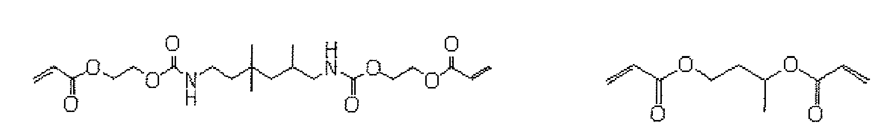

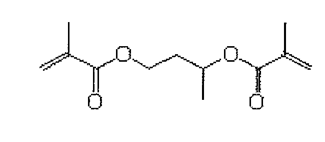

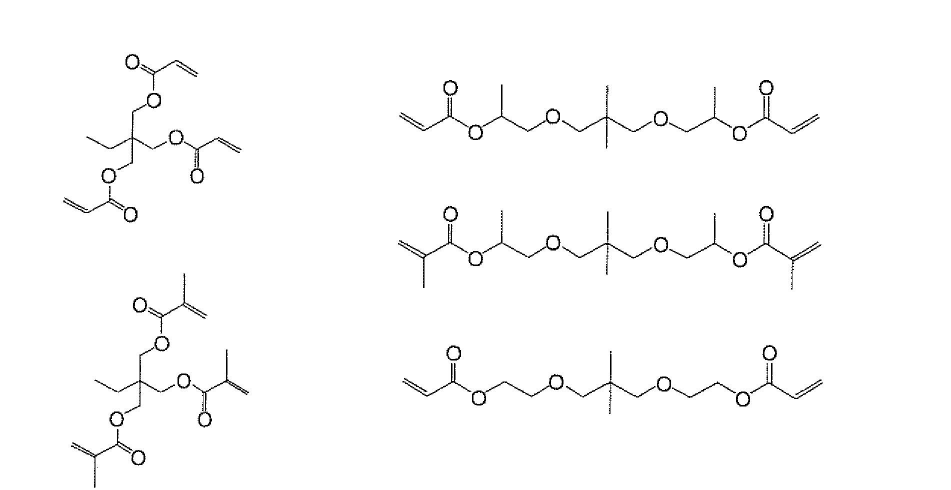

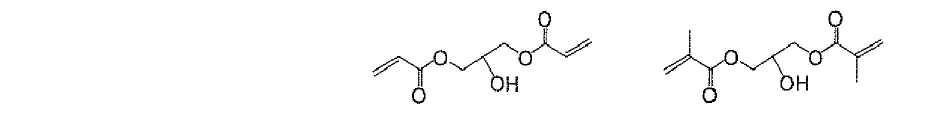

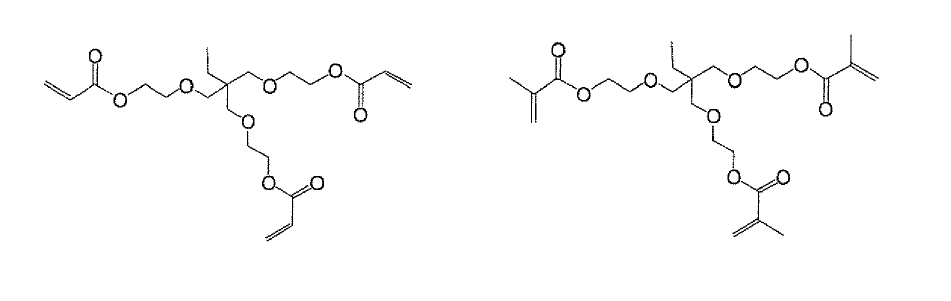

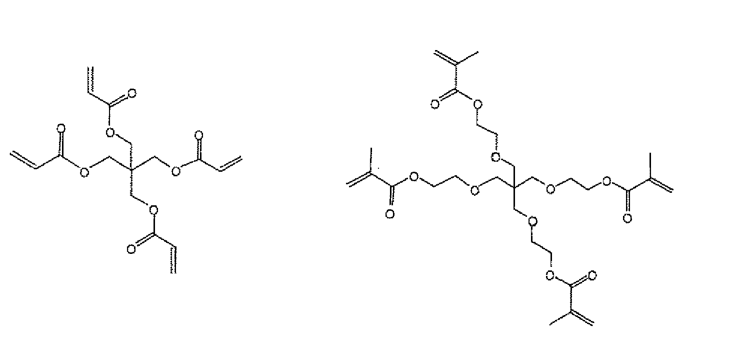

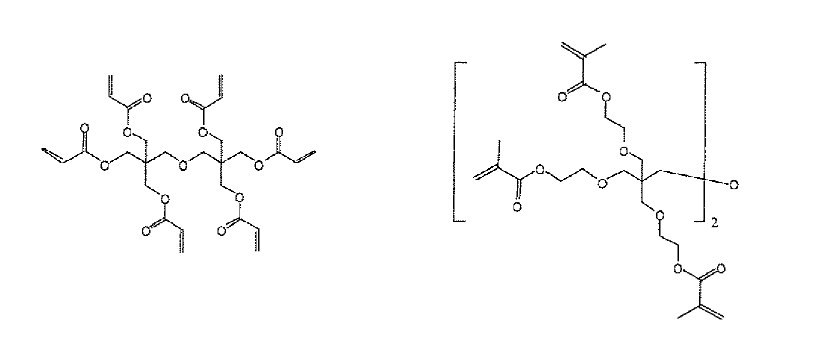

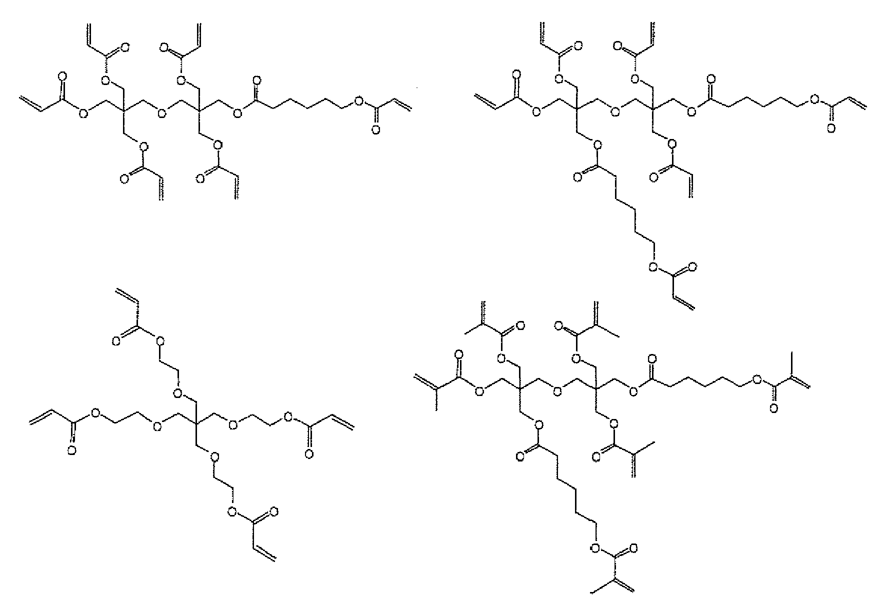

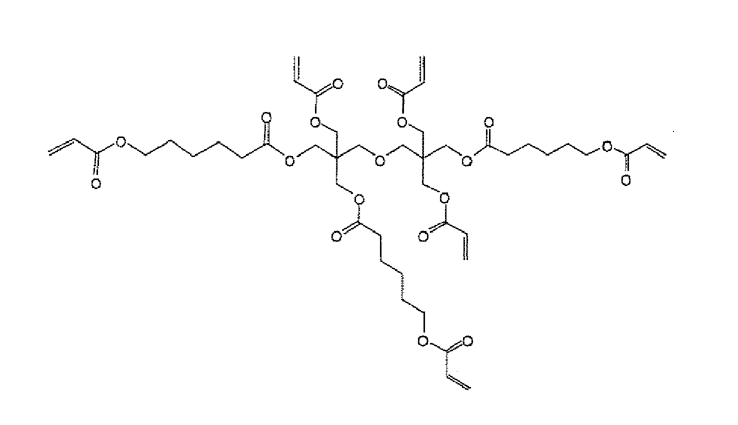

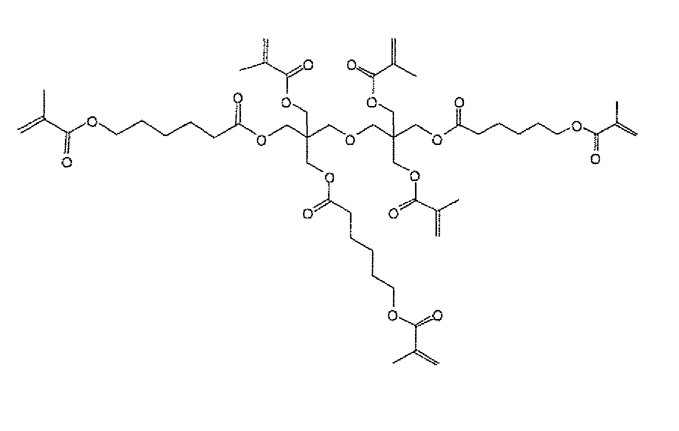

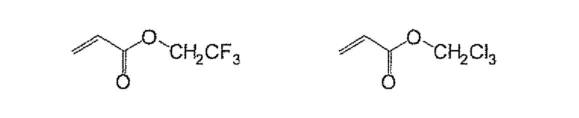

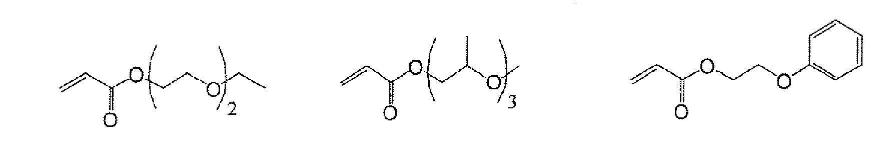

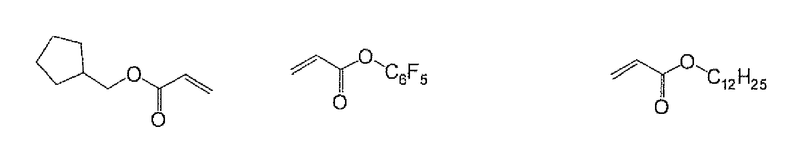

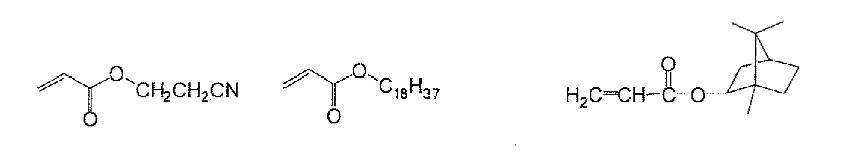

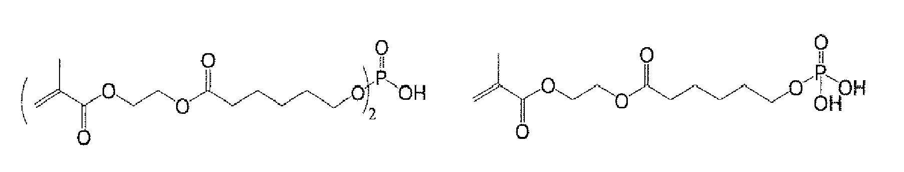

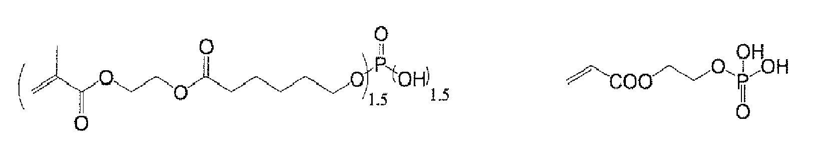

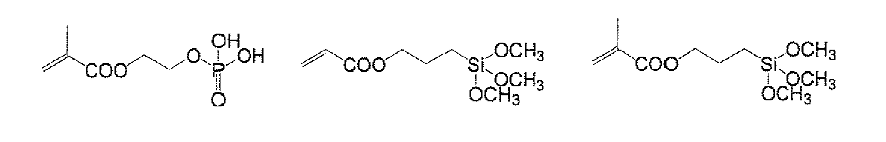

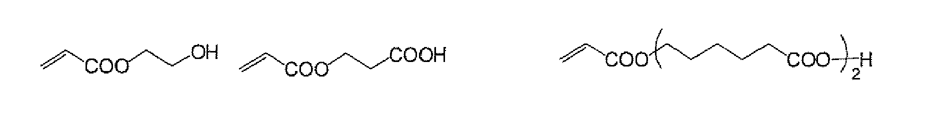

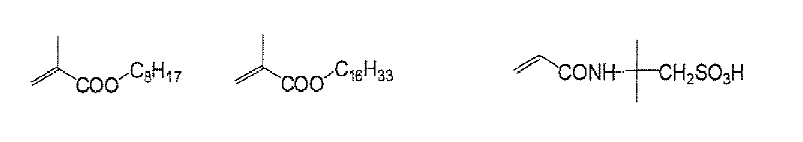

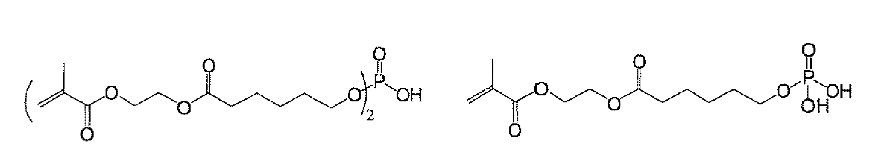

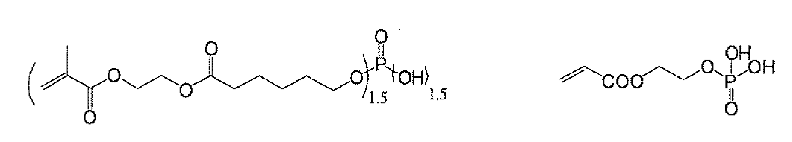

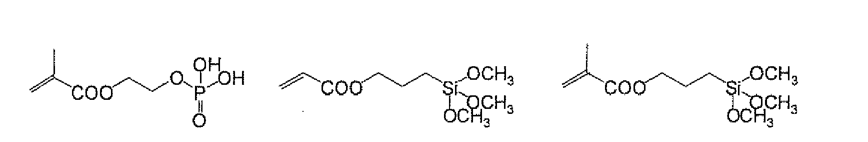

### (3) Blend Ratio of Photopolymerization Initiator and Polymerizing Compound:

In the composition of the organic layer in the invention, the blend ratio by weight of the polymerizing compound to the photopolymerization initiator before the start of photopolymerization is preferably from 100/1 to 100/30, more preferably from 100/3 to 100/10.

### (4)Method of formation of organic layer

The method for forming the organic layer is not specifically defined. For example, the layer may be formed according to a solution coating method or a vacuum film formation method. The solution coating method is, for example, a dipping method, an air knife coating method, a curtain coating method, a roller coating method, a wire bar coating method, a gravure coating method, a slide coating method, or an extrusion coating method using a hopper as in USP 2681294. The vacuum film formation method is not specifically defined, but is preferably a film formation method by vapor deposition or plasma CVD. In the invention, the polymer may be applied for coating as its solution, or a hybrid coating method along with an inorganic material, as in JP-A 2000-323273 and 2004-25732, may also be used.

The light for irradiation is generally a UV ray from a high-pressure mercury lamp or low-pressure mercury lamp. The radiation energy is preferably at least 0.5 J/cm², more preferably at least 2 J/cm². Acrylate and methacrylate may suffer from interference in polymerization owing to oxygen in air, and therefore, in their polymerization, the oxygen concentration or the oxygen partial pressure is preferably lowered. In the case where the oxygen concentration in polymerization is lowered according to a nitrogen purging method, the oxygen concentration is preferably at most 2 %, more preferably at most 0.5 %. In the case where the oxygen partial pressure in polymerization is lowered by a pressure reduction method, the whole pressure is preferably at most 1000 Pa, more preferably at most 100 Pa. Especially preferred is UV polymerization with at least 2 J/cm² energy radiation under a condition of reduced pressure of at most 100 Pa.

The organic layer is preferably smooth. The mean roughness (Ra) of 10 µm² of the organic layer is preferably at most 10 nm, more preferably at most 2 nm, further more preferably at most 1 nm. Preferably, the rate of polymerization of monomer is at least 85 %, more preferably at least 88 %, even more preferably at least 90 %, still more preferably at least 92 %. The rate of polymerization as referred to herein means the ratio of the reacted polymerizing group to all the polymerizing group (acryloyl group and methacryloyl group) in the monomer mixture. The rate of polymerization may be quantitatively determined according to IR absorptiometry.

The thickness of the organic layer is not specifically defined. However, when the layer is too thin, then its thickness could hardly keep uniformity; but when too thick, the layer may be cracked by external force applied thereto and its barrier-property may lower. From these viewpoints, the thickness of the organic layer is preferably from 50 nm to 2000 nm, more preferably from 200 nm to 1500 nm.

As so mentioned in the above, the organic layer is preferably smooth. The surface of the organic layer is required not to have impurities and projections such as particles. Accordingly, it is desirable that the organic layer is formed in a clean room. The degree of cleanness is preferably at most class 10000, more preferably at most class 1000.

Preferably, the hardness of the organic layer is higher. It is known that, when the hardness of the organic layer is high, then the inorganic layer may be formed smoothly and, as a result, the barrier level of the gas barrier film is thereby improved. The hardness of the organic layer may be expressed as a microhardness based on a nano-indentation method. The microhardness of the organic layer is preferably at least 150 N/mm, more preferably at least 180 N/mm, even more preferably at least 200 N/mm.

Two or more organic layers may be laminated. In this case, each layer may have the same composition or may have different compositions. In the case where two or more organic layers are laminated, they are preferably so designed that each organic layer could fall within the above-mentioned preferred range. As so mentioned in the above, the organic layer may be included as a layer have a composition continuously changing in the direction of the layer thickness with no definite interface between an organic layer and an inorganic layer, as illustrated in USP-A 2004-46497.

### (Inorganic Layer)

The inorganic layer is, in general, a layer of a thin film formed of a metal compound. For forming the inorganic layer, employable is any method capable of producing the intended thin film. For it, for example, suitable are physical vapor deposition methods (PVD) such as vapor evaporation method, sputtering method, ion plating method; various chemical vapor deposition methods (CVD); liquid phase growth methods such as plating or sol-gel method. Of those, preferred are physical vapor deposition methods (PVD) and chemical vapor deposition methods (CVD), which may evade thermal influences on the substrate film in inorganic layer formation, and which may readily produce uniform thin film layers at rapid production speed. Not specifically defined, the component to be in the inorganic layer may be any one satisfies the above-mentioned requirements. For example, it includes oxides, nitrides or oxinitrides containing at least one metal selected from Si, Al, In, Sn, Zn, Ti, Cu, Ce and Ta. Of those, preferred are oxides, nitrides or oxinitrides of a metal selected from Si, Al, In, Sn, Zn and Ti; more preferred are metal oxides, nitrides or oxinitrides with Si or Al. These may contain any other element as a subsidiary component.

Preferably, the surface smoothness of the inorganic layer formed in the invention is less than 2 nm in terms of the mean roughness (Ra value) in 10 µm square, more preferably at most 1 nm. Accordingly, it is desirable that the inorganic layer is formed in a clean room. Preferably, the degree of cleanness is at most class 10000, more preferably at most class 1000.

Not specifically defined, the thickness of the inorganic layer is generally within a range of from 5 to 500 nm/layer. The laminate and the barrier film substrate of the invention exhibit good barrier property even though the inorganic layer therein is thin, and therefore, the inorganic layer is preferably as thin as possible for increasing the producibility and for reducing the cost. The thickness of the inorganic layer is preferably from 20 to 200 nm.

Two or more inorganic layers may be laminated. In such a case, the individual layers may have the same composition or different compositions. In case where two or more layers are laminated, it is desirable that the individual inorganic layers are so designed as to fall within the above-mentioned preferred ranges. In addition, as so mentioned hereinabove and as disclosed in UP Laid-Open 2004-46497, the inorganic layers may be gradation layers of which the composition changes continuously in the thickness direction of the layer, with no definite boundary to the adjacent inorganic layer.

### (Lamination of Organic Layer and Inorganic Layer)

The organic layer and the inorganic layer may be laminated by repeated film formation to form the organic layer and the inorganic layer in a desired layer constitution. In case where the inorganic layer is formed according to a vacuum film formation method such as sputtering method, vacuum evaporation method, ion plating method or plasma CVD method, then it is desirable that the organic layer is also formed according to a vacuum film formation method such as the above-mentioned flash vapor deposition method. While the barrier layer is formed, it is especially desirable that the organic layer and the inorganic layer are laminated all the time in a vacuum of at most 1000 Pa, not restoring the pressure to an atmospheric pressure during the film formation. More preferably, the pressure is at most 100 Pa, even more preferably at most 50 Pa, still more preferably at most 20 Pa.

### (Functional Layer)

The device of the invention may have a functional layer on the barrier laminate or in any other position. The functional layer is described in detail in JP-A 2006-289627, paragraphs 0036 to 0038. Examples of other functional layers than those are a matting agent layer, a protective layer, an antistatic layer, a planarizing layer, an adhesiveness improving layer, a light shielding layer, an antireflection layer, a hard coat layer, a stress relaxing layer, an antifogging layer, an anti-soiling layer, a printable layer, an adhesive layer, etc.

### (Use of Barrier Laminate)

In general, the barrier laminate of the invention is formed on a support. Selecting the support, the barrier laminate may have various applications. The support includes a substrate film, as well as various devices, optical members, etc. Concretely, the barrier laminate of the invention may be used as a barrier layer of a barrier film substrate. The barrier laminate and the barrier film substrate of the invention may be used for sealing up devices that require gas-barrier performance. The barrier laminate and the barrier film substrate of the invention may apply optical members. These are described in detail hereinunder.

### <Barrier Film Substrate>

The barrier film substrate comprises a substrate film and a barrier laminate formed on the substrate film. In the barrier film substrate, the barrier laminate of the invention may be provided only one surface of the substrate film, or may be provided on both surfaces thereof. The barrier laminate of the invention may be laminated in an order of an inorganic layer and an organic layer from the side of the substrate film; or may be laminated in an order of an organic layer and an inorganic layer from it. The uppermost layer of the laminate of the invention may be an inorganic layer or an organic layer.

The barrier film substrate of the invention is a film substrate having a barrier layer that functions to block oxygen, water, nitrogen oxide, sulfur oxide, ozone and others in air.

Not specifically defined, the number of the layers that constitute the barrier film substrate may be typically from 2 layers to 30 layers, more preferably from 3 layers to 20 layers.

The barrier film substrate may have any other constitutive components (e.g., functional layers such as adhesive layer) in addition to the barrier laminate and the substrate film. The functional layer may be disposed on the barrier laminate, or between the barrier laminate and the substrate film, or on the side (back) of the substrate film not coated with the barrier laminate.

### (Plastic Film)

In the barrier film substrate of the invention, the substrate film is generally a plastic film. Not specifically defined in point of the material and the thickness thereof, the plastic film usable herein may be any one capable of supporting a laminate of an organic layer and an inorganic layer; and it may be suitably selected depending on the use and the object thereof. Concretely, the plastic film includes thermoplastic resins such as polyester resin, methacryl resin, methacrylic acid-maleic anhydride copolymer, polystyrene resin, transparent fluororesin, polyimide, fluoropolyimide resin, polyamide resin, polyamidimide resin, polyetherimide resin, cellulose acylate resin, polyurethane resin, polyether ether ketone resin, polycarbonate resin, alicyclic polyolefin resin, polyarylate resin, polyether sulfone resin, polysulfone resin, cycloolefin copolymer, fluorene ring-modified polycarbonate resin, alicyclic-modified polycarbonate resin, fluorene ring-modified polyester resin, acryloyl compound.

In case where the barrier film substrate of the invention is used as a substrate of a device such as an organic EL device to be mentioned hereinunder, it is desirable that the plastic film is formed of a heat-resistant material. Concretely, the plastic film is preferably formed of a heat-resistant transparent material having a glass transition temperature (Tg) of not lower than 100°C and/or a linear thermal expansion coefficient of at least 40 ppm/°C. Tg and the linear expansion coefficient may be controlled by the additives to the material. The thermoplastic resin of the type includes, for example, polyethylene naphthalate (PEN: 120°C), polycarbonate (PC: 140°C), alicyclic polyolefin (e.g., Nippon Zeon's Zeonoa 1600: 160°C), polyarylate (PAr: 210°C), polyether sulfone (PES: 220°C), polysulfone (PSF: 190°C), cycloolefin copolymer (COC, compound described in JP-A 2001-150584: 162°C), fluorene ring-modified polycarbonate (BCF-PC, compound described in JP-A 2000-227603: 225°C), alicyclic-modified polycarbonate (IP-PC, compound described in JP-A 2000-227603: 205°C), acryloyl compound (compound described in JP-A 2002-80616: 300°C or more) (the parenthesized data are Tg). In particular, for high transparency, use of alicyclic polyolefin is preferred.

Since the barrier film substrate of the invention is usable in devices such as organic EL devices, the plastic film is transparent, or that is, its light transmittance is generally at least 80%, preferably at least 85%, more preferably at least 90%. The light transmittance may be measured according to the method described in JIS-K7105. Concretely, using an integrating sphere-type light transmittance meter, a whole light transmittance and a quantity of scattered light are measured, and the diffusive transmittance is subtracted from the whole transmittance to obtain the intended light transmittance of the sample.

Even when the barrier film substrate of the invention is used in displays, it does not always require transparency in a case where it is not disposed on the viewers' side. Accordingly in such a case, a nontransparent material may be used for the plastic film. The nontransparent material includes, for example, polyimide, polyacrylonitrile, known liquid-crystal polymer.

Not specifically defined, the thickness of the plastic film for use in the barrier film substrate of the invention may be suitably selected depending on its use. Typically, the thickness may be from 1 to 800 µm, preferably from 10 to 200 µm. The plastic film may have a functional layer such as a transparent conductive layer, a primer layer, etc. The functional layer is described in detail in JP-A 2006-289627, paragraphs 0036 to 0038. Examples of other functional layers than those are a matting agent layer, a protective layer, an antistatic layer, a planarizing layer, an adhesiveness improving layer, a light shielding layer, an antireflection layer, a hard coat layer, a stress relaxing layer, an antifogging layer, an anti-soiling layer, a printable layer, an adhesive layer, etc.

### <Device>

The barrier laminate and the barrier film substrate of the invention are favorably used for devices that are deteriorated by the chemical components in air (e.g., oxygen, water, nitrogen oxide, sulfur oxide, ozone). Examples of the devices are, for example, organic EL devices, liquid-crystal display devices, thin-film transistors, touch panels, electronic papers, solar cells, other electronic devices. More preferred are organic EL devices.

The barrier laminate of the invention may be used for film-sealing of devices. Specifically, this is a method of providing a barrier laminate of the invention on the surface of a device serving as a support by itself. Before providing the barrier laminate, the device may be covered with a protective layer.

The barrier film substrate of the invention may be used as a substrate of a device or as a film for sealing up according to a solid sealing method. The solid sealing method comprises forming a protective layer on a device, then forming an adhesive layer and a barrier film substrate as laminated thereon, and curing it. Not specifically defined, the adhesive may be a thermosetting epoxy resin, a photocurable acrylate resin, etc.

### (Organic EL Device)

Examples of an organic EL device with a barrier film substrate are described in detail in JP-A 2007-30387.

### (Liquid-Crystal Display Device)

A reflection-type liquid-crystal display device has a constitution of a lower substrate, a reflection electrode, a lower alignment film, a liquid-crystal layer, an upper alignment film, a transparent electrode, an upper substrate, a λ/4 plate and a polarizing film, formed in that order from the bottom. In this, the barrier film substrate of the invention may be used as the transparent electrode substrate and the upper substrate. In color displays, it is desirable that a color filter layer is additionally provided between the reflection electrode and the lower alignment film, or between the upper alignment film and the transparent electrode. A transmission-type liquid-crystal display device has a constitution of a backlight, a polarizer, a λ/4 plate, a lower transparent electrode, a lower alignment film, a liquid-crystal layer, an upper alignment film, an upper transparent electrode, an upper substrate, a λ/4 plate and a polarizing film, formed in that order from the bottom. In this, the substrate of the invention may be sued as the upper transparent electrode and the upper substrate. In color displays, it is desirable that a color filter layer is additionally provided between the lower transparent electrode and the lower alignment film, or between the upper alignment film and the transparent electrode. Not specifically defined, the type of the liquid-crystal cell is preferably a TN (twisted nematic) type, an STN (supertwisted nematic) type, a HAN (hybrid aligned nematic) type, a VA (vertically alignment) type, an ECB (electrically controlled birefringence) type, an OCB (optically compensatory bent) type, a CPA (continuous pinwheel alignment) type, or an IPS (in-plane switching) type.

### (Others)

Other applications of the invention are thin-film transistors as in JP-T 10-512104, touch panels as in JP-A 5-127822, 2002-48913, electronic papers as in JP-A 2000-98326, and solar cells as in Japanese Patent Application No. 7-160334.

### <Optical Member>

An example of the optical member that comprises the barrier laminate of the invention is a circular polarizer.

### (Circular Polarizer)

Laminating a barrier film substrate of the invention with a λ/4 plate and a polarizer gives a circular polarizer. In this case, the components are so laminated that the slow axis of the λ/4 plate could cross the absorption axis of the polarizer at an angle of 45°. The polarizer is preferably stretched in the direction of 45° from the machine direction (MD) thereof; and for example, those described in JP-A 2002-865554 are favorably used.

### (Solar Cell)

The gas-barrier film of the invention can be used also as a sealing film for solar cell devices. Preferably, the gas-barrier film of the invention is used for sealing a solar cell device in such a manner that its adhesive layer is on the side near to the solar cell device. The solar cell devices for which the gas-barrier film of the invention is favorably used are not specifically defined. For example, they include single crystal silicon-based solar cell devices, polycrystalline silicon-based solar cell devices, single-junction or tandem-structure amorphous silicon-based solar cell devices, gallium-arsenic (GaAs), indium-phosphorus (InP) or the like III-V Group compound semiconductor-based solar cell devices, cadmium-tellurium (CdTe) or the like II-VI Group compound semiconductor-based solar cell devices, copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices, dye-sensitized solar cell devices, organic solar cell devices, etc. Above all, in the invention, the solar cell devices are preferably copper/indium/selenium (CIS-based), copper/indium/gallium/selenium (CIGS-based), copper/indium/gallium/selenium/sulfur (CIGSS-based) or the like I-III-VI Group compound semiconductor-based solar cell devices.

### EXAMPLES

The characteristics of the invention are described more concretely with reference to the following Examples. In the following Examples, the material used, its amount and the ratio, the details of the treatment and the treatment process may be suitably modified or changed not overstepping the sprit and the scope of the invention. Accordingly, the invention should not be limitatively interpreted by the Examples mentioned below.

### Example A: Production of barrier film substrate comprising substrate film/organic layer/inorganic layer:

A coating liquid having the composition shown in Table 1 below was prepared, using methyl ethyl ketone, and applied onto a substrate film (Toray's Lumirror T60, having a thickness of 100 µm) to form a film thereon having a dry film thickness of 1000 nm, and then cured through irradiation with UV rays at a dose of 0.5 J/cm² in an atmosphere having 200 ppm of nitrogen. Aluminium oxide was deposited on the surface of the formed organic layer according to a sputtering method, thereby producing a barrier film substrate of Examples 1 to 13 and Comparative Examples 1 to 3. Aluminium acted as a target of the cathode, the discharge gas was argon, and the reaction gas was oxygen. The film formation pressure was 0.1 Pa; and the ultimate film thickness was 60 nm.

The obtained barrier film was tested and evaluated for the water vapor permeability (MOCON's method and Ca method) and the number of defects according to the test methods mentioned below. The test results are shown in Table 2.
[Water Vapor Permeability (g/m²/day)]:

### (1) MOCON method:

Determined with MOCON's "PERMATRAN-W3/31" (40°C, 90 % RH). In Table 2, "<0.01" means that the water vapor permeability is less than 0.01 g/m²·day.

### (2) Ca method:

The samples of which the water vapor permeability is lower than the detection limit in the MOCON method are analyzed for the water vapor permeability thereof at 40°C and 90 % RH according to the method described in the reference mentioned below.

### <Reference>

G. NISATO, P.C.P. BOUTEN, P.J. SLIKKERVEER, et al.; SID Conference Record of the International Display Research Conference 1435-1438.

### <Counting of Number of Defects>

Using a scanning electromicroscope, Hitachi's S-4100 Model at a power of 500 magnifications and at an accelerating voltage of 5 kV, 100 spots of 1 mm² each are extracted at random from the barrier film substrate produced in the above. In the thus-selected spots, the number of defects is counted, and the data are averaged to give a mean value. The defected counted in this test are those having a maximum length of at least 1 µm. The mean value is converted into a value per cm², and this is the number of defects of the tested sample.

**Table 1**

| | Composition of Organic Layer | | Remarks |
|---|---|---|---|
| | Photopolymerization Initiator 1.5 wt.pts. | Polymerizing Compound 20 wt.pts. | |
| Example 1 | Compound of Formula (B), when n = 2 | Daicel Cytec's aliphatic modified epoxy acrylate, EBECRYL 3702, bifunctional | sample of the invention |
| Example 2 | Compound of Formula (B), when n = 5 | Daicel Cytec's aliphatic modified epoxy acrylate, EBECRYL 3702, bifunctional | sample of the invention |
| Example 3 | Compound of Formula (B), when n = 10 | Daicel Cytec's aliphatic modified epoxy acrylate, EBECRYL 3702, bifunctional | sample of the invention |
| Example 4 | Compound of Formula (B), when n = 20 | Daicel Cytec's aliphatic modified epoxy acrylate, EBECRYL 3702, bifunctional | sample of the invention |
| Example 5 | Compound of Formula (B), when n = 48 | Daicel Cytec's aliphatic modified epoxy acrylate, EBECRYL 3702, bifunctional | sample of the invention |
| Example 6 | Compound of Formula (B), when n = 5 | Kyoeisha Chemical's 1,9-nonanediol diacrylate, 1.9ND-A, bifunctional | sample of the invention |
| Example 7 | Compound of Formula (B), when n = 2 to 5 | Daicel Cytec's dipentaerythritol hexaacrylate, DPHA, hexafunctional | sample of the invention |
| Example 8 | Compound of Formula (B), when n = 2 to 5 | Daicel Cytec's dipentaerythritol ethoxy tetraacrylate, EBECRYL40, tetrafunctional | sample of the invention |
| Example 9 | Compound of Formula (B), when n = 2 to 5 | Daicel Cytec's urethane acrylate, EBECRYL 1290K, hexafunctional | sample of the invention |
| Example 10 | Compound of Formula (B), when n = 2 to 5 | Daicel Cytec's urethane acrylate, EBECRYL 9260, trifunctional | sample of the invention |
| Example 11 | Compound of Formula (B), when n = 2 to 5 | Daicel Cytec's aliphatic modified epoxy acrylate, EBECRYL 3702, bifunctional | sample of the invention |
| Example 12 | Mixture of Compounds of Formula (C) | Daicel Cytec's aliphatic modified epoxy acrylate, EBECRYL 3702, bifunctional | sample of the invention |
| Example 13 | Mixture of Compounds of Formula (D) | Daicel Cytec's aliphatic modified epoxy acrylate, EBECRYL 3702, bifunctional | sample of the invention |
| Comparative Example 1 | Ciba Speciality Chemicals' IRGACURE 907 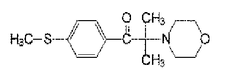 | Daicel Cytec's aliphatic modified epoxy acrylate, EBECRYL 3702, bifunctional | comparative sample |
| Comparative Example 2 | Ciba Speciality Chemicals' IRGACURE 651 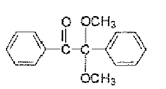 | Daicel Cytec's aliphatic modified epoxy acrylate, EBECRYL 3702, bifunctional | comparative sample |
| Comparative Example 3 | Ciba Speciality Chemicals' IRGACURE 907 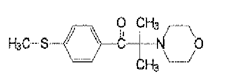 | Kyoeisha Chemical's 1,9-nonanediol diacrylate, 1.9ND-A, bifunctional | comparative sample |

In the above Table 1, the compound of formula (B), the mixture of compounds of formula (C) and the mixture of compounds of formula (D) are shown below.

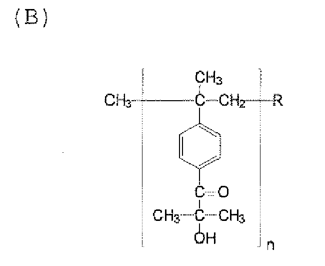

In formula (B), R means an ethyl group, and n indicates the number shown in Table 1. The compounds in Examples 1 to 6 were produced. The compound of formula (B) where n is from 2 to 5 is available as Esacure KIP150 (trade name by Lamberti, sold by Sartomer).

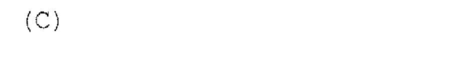

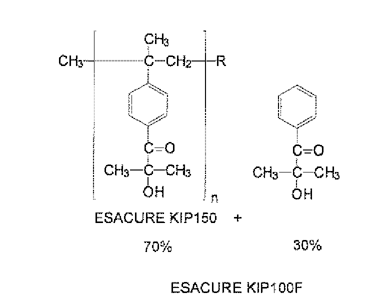

In formula (C), R means an ethyl group, and n indicates an integer of from 2 to 5. This is available as Esacure KIP100F (trade name by Lamberti, sold by Sartomer).

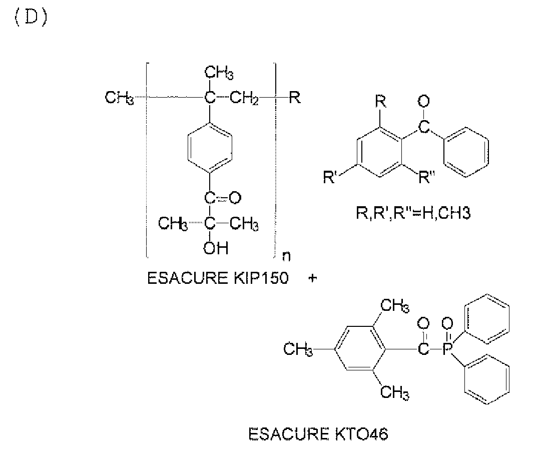

In formula (D), R means an ethyl group, and n indicates an integer of from 2 to 5. This is available as Esacure KTO46 (trade name by Lamberti, sold by Sartomer).

**Table 2**

| | Water Vapor Permeability (MOCON method) | Water Vapor Permeability (Ca method) | Number of defects (/cm²) |
|---|---|---|---|
| Example 1 | <0.01 | 0.004 | 103 |
| Example 2 | <0.01 | 0.0009 | 20 |
| Example 3 | <0.01 | 0.0008 | 19 |
| Example 4 | <0.01 | 0.0008 | 18 |
| Example 5 | <0.01 | 0.0007 | 16 |
| Example 6 | <0.01 | 0.0008 | 19 |
| Example 7 | <0.01 | 0.001 | 31 |
| Example 8 | <0.01 | 0.001 | 26 |
| Example 9 | <0.01 | 0.0015 | 38 |
| Example 10 | <0.01 | 0.002 | 55 |
| Example 11 | <0.01 | 0.003 | 72 |
| Example 12 | <0.01 | 0.005 | 115 |
| Example 13 | <0.01 | 0.005 | 122 |
| Comparative Example 1 | 0.03 | - | >500 |
| Comparative Example 2 | 0.03 | - | >500 |
| Comparative Example 3 | 0.02 | - | >500 |

From Table 2, it is known that, in the barrier film substrates produced by the use of a specific photopolymerization initiator in the invention, the number of defects per the unit area, as detected in observation with a scanning electromicroscope, is smaller than that in the comparative barrier film substrates, and the barrier film substrates of the invention have a higher barrier capability (having a lower water vapor permeability). Above all, the number of defects in the barrier film substrates of Examples 2 to 6 is remarkably small. In these Examples, one radical generated is a propoxy radical (after hydrogenation, its molecular weight is 60), and the other is an oligomer having a molecular weight of at least 700. This means that no volatile component remained in the organic layer formed in these Examples.

On the other hand, in Example 1, the oligomer is a dimer (n = 2, molecular weight 334), and therefore the volatile-preventing effect thereof is relatively low, and the number of defects is relatively large. Also in Examples 7 to 10, the layer formed contains a dimer and therefore its volatile-preventing effect is relatively low. In Examples 11 and 12, used is a low-molecular-weight polymerization initiator, and therefore, the volatile-preventing effect of the layer formed is relatively low.

### Example B:

In Example 6 and Comparative Example 3, the organic layer was formed according to a flash vapor deposition method but not according to the coating method. These also attained the same effects as in Example A.

### Example C:

Barrier film substrates having the layer constitution as in Table 3 below were produced. In these, the substrate film was the same as in Example A. The inorganic layer was formed in the same manner as in Example A. In Examples 14, 15 and 16, the organic layer was formed like the organic layer in Example 11; and in Comparative Examples 4, 5 and 6, the organic layer was formed like the organic layer in Comparative Example 1.

**Table 3**

| | Layer Constitution |
|---|---|
| Example 14 | substrate film/organic layer/inorganic layer/organic layer/inorganic layer |
| Comparative Example 4 | inorganic layer/organic layer/inorganic layer/organic layer/inorganic layer/organic layer/substrate film/organic layer/inorganic layer/organic layer/inorganic layer/organic layer/inorganic layer |
| Example 15 | inorganic layer/organic layer/inorganic layer/organic layer/substrate film/organic layer/inorganic layer/organic layer/inorganic layer |
| Comparative Example 5 | inorganic layer/organic layer/inorganic layer/organic layer/inorganic layer/organic layer/substrate film/organic layer/inorganic layer/organic layer/inorganic layer/organic layer/inorganic layer |
| Example 16 | inorganic layer/organic layer/inorganic layer/organic layer/inorganic layer/organic layer/substrate film/organic layer/inorganic layer/organic layer/inorganic layer/organic layer/inorganic layer |
| Comparative | inorganic layer/organic layer/inorganic |
| Example 6 | layer/organic layer/inorganic layer/organic layer/substrate film/organic layer/inorganic layer/organic layer/inorganic layer/organic layer/inorganic layer |

### Production of Organic EL Device:

Using the barrier film substrate obtained in the above, an organic EL device was produced. Concretely, an ITO film-having conductive glass substrate (surface resistivity, 10 Ω/square) was washed with 2-propanol, and then processed for UV ozone treatment for 10 minutes. On the substrate (anode), the following compound layers were formed in order by vapor deposition according to a vacuum vapor deposition method.

### (First Hole Transporting Layer)

Copper phthalocyanine: film thickness 10 nm.

### (Second Hole Transporting Layer)

N,N'-diphenyl-N,N'-dinaphthylbenzidine: film thickness 40 nm.

### (Light-Emitting Layer also serving as electron transporting layer)

Tris(8-hydroxyquinolinato)aluminium: film thickness 60 nm.

### (Electron Injection Layer)

Lithium fluoride: film thickness 1 nm.

A metal aluminium was formed on it through vapor deposition to form a cathode having a thickness of 100 nm, and a silicon nitride film having a thickness of 3 µm was formed thereon according to a parallel plate CVD method, thereby constructing an organic EL device.

Next, using a thermosetting adhesive (Epotec 310, by Daizo-Nichimori), the barrier film substrate of Examples 11, 14 to 16 and Comparative Example 1, 4 to 6 and the organic EL device were stuck together in such a manner that the side of the barrier film substrate laminated with organic layers and inorganic layers (in case where these layers were laminated on both surfaces, any one of the coated surfaces) could be on the side of the organic EL device, and heated at 65°C for 3 hours to cure the adhesive. 20 test pieces of every sample of the thus-sealed organic EL device were prepared.

Just after produced, the organic EL device was tested for light emission under application of 7 V thereto, using a source measure unit (SMU2400 Model by Keithley). Using a microscope, the light-emitting surface was observed, which confirmed uniform light emission by every device with no dark spot.

Finally, the devices were stored in a dark room at 60°C and 90 % RH for 24 hours, and then tested for light emission. The proportion of the test pieces that gave dark spots larger than 300 µm in diameter is defined as a failure rate. The failure rate of every sample was computed. The results are shown in Table 4.

**Table 4**

| | Failure Rate of Device | |
|---|---|---|
| Example 11 | 5/20=25% | sample of the invention |
| Example 14 | 3/20=15% | sample of the invention |
| Example 15 | 1/20= 5% | sample of the invention |
| Example 16 | 0/20= 0% | sample of the invention |
| Comparative Example 1 | 8/20=40% | comparative sample |
| Comparative Example 4 | 6/20=30% | comparative sample |
| Comparative Example 5 | 2/20=10% | comparative sample |
| Comparative Example 6 | 0/20= 0% | comparative sample |

As is obvious from the above results, it is known that the barrier film substrates of the invention can reduce the failure rate of the devices. Further, it is known that, even when the number of the laminated layers is reduced in the barrier film substrates of the invention, the failure rate is still low, and therefore, the number of the laminated layers in the invention can be reduced and the producibility is increased. It is further confirmed that the offensive smell of the volatile component from the polymerization initiators used in the Examples of the invention in polymerization was significantly reduced as compared with that from the polymerization initiators used in the Comparative Examples.

### Example D:

The organic EL device comprising the barrier film substrate of Example 16 or Comparative Example 6 was continuously kept on at 500 cd/m², which is necessary for TV and others, and the its brightness was determined. The device of Example 16 took 2000 hours before its brightness lowered to 300 cd/square, and that of Comparative Example 4 took 1600 hours. Specifically, the failure rate of the organic EL device comprising the barrier film substrate of Comparative Example 6 was low, but the time taken by the device before its brightness lowered to 300 cd/square was 80 % of the time taken by the device of Example 16, or that is, the barrier film substrate of Comparative Example 6 deteriorated earlier as compared with that of Example 16.

The barrier film substrate of Example 16 and Comparative Example 6 was cut into a piece of 40 mm x 80 mm in size, and at 25°C and 60 % RH, its haze was measured with a haze meter (HGM-2DP, by Suga Test Instruments) according to JIS K-6714. The haze of the film of Example 16 was 0.8 %; and that of Comparative Example 6 was 1.1 %. This confirms the high transparency of the film of the invention.

### Example E:

In place of sticking the barrier film substrate of Examples 11, 14 to 16 and Comparative Example 1, 4 to 6 to the organic EL device in Example C, a barrier laminate having the same layer constitution as in Examples 11, 14 to 16 and Comparative Example 1, 4 to 6 was directly provided on the organic EL device, and the others were the same as in Example C thereby sealing up the organic EL device. It is known that the failure rate of the organic EL devices sealed up with the barrier laminate of the invention is reduced.

### INDUSTRIAL APPLICABILITY

The barrier laminate and the barrier film substrate of the invention have an excellent barrier property, and when used in devices such as organic EL devices, they are significantly effective for preventing the devices from being deteriorated and for reducing failed devices. In addition, in the barrier laminate and the barrier film substrate of the invention, the organic layer is formed by the use of a polyfunctional polymerization initiator and the offensive smell in forming the organic layer may be reduced. Further, the barrier laminate and the barrier film substrate of the invention are excellent in transparency, and therefore, their applications in broader ranges are expected, exceeding conventional barrier film substrates.

## Claims

1. A barrier laminate having at least one organic layer and at least one inorganic layer, wherein the organic layer is formed by curing a composition containing a polymerizing compound and a photopolymerization initiator having at least two sites capable of initiating polymerization in one molecule, through irradiation with light.

2. The barrier laminate of Claim 1, wherein the photopolymerization initiator is a compound containing a structural unit of the following formula (A): 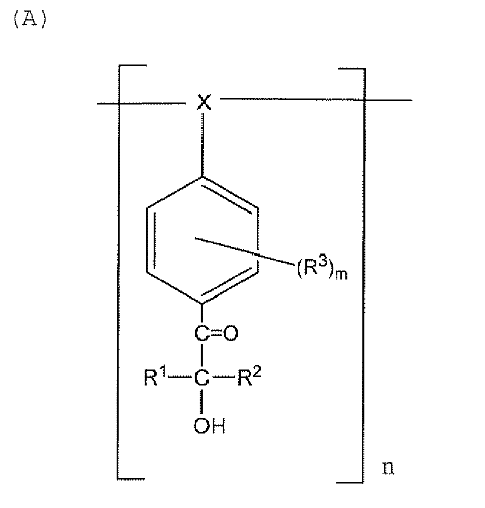 (wherein X represents a linear alkylene group or a branched alkylene group; R¹ and R² each represent a linear alkyl group or a branched alkyl group; R³ represents a substituent; m indicates an integer of from 0 to 4; n indicates an integer of from 2 to 50).

3. The barrier laminate of Claim 2, wherein n is an integer of from 2 to 20.

4. The barrier laminate of any one of Claims 1 to 3, wherein the molecular weight of the non-radical component of the photopolymerization initiator is less than 70 or at least 600.

5. The barrier laminate of any one of Claims 1 to 4, wherein the polymerizing compound is an acrylate compound.

6. The barrier laminate of any one of Claims 1 to 5, wherein at least two organic layers and at least two inorganic layers are alternately laminated.

7. A barrier film substrate comprising a substrate film and a barrier laminate of any one of Claims 1 to 6 provided on the substrate film.

8. A barrier film substrate comprising a substrate film and a barrier laminate having at least one organic layer and at least one inorganic layer on the substrate film, wherein the number of the defects having a length of at least 1 µm in the surface of the barrier laminate is at most 30/cm².

9. The barrier film substrate of Claim 8, wherein the barrier laminate is a barrier laminate of any one of Claims 1 to 6.

10. A device comprising a barrier film substrate of any one of Claims 7 to 9 as the substrate thereof.

11. A device sealed up with a barrier film substrate of any one of Claims 7 to 9.

12. A device sealed up with a barrier laminate of any one of Claims 1 to 6.

13. A method for producing a barrier laminate comprising providing at least one organic layer and at least one inorganic layer on a support, wherein the organic layer is provided by curing a composition containing a polymerizing compound and a photopolymerization initiator having plural sites capable of initiating polymerization in one molecule, through irradiation with light.

14. The method for producing a barrier laminate of Claim 13, wherein the inorganic layer is provided by vacuum vapor deposition.

15. An optical part comprising a barrier film substrate of Claim 9 as the substrate thereof.
